# EUROPEAN PATENT APPLICATION

(11) **EP 4 848 910 A1**
(43) Date of publication of application: **02.12.2026**
(21) Application number: 25179546.4
(22) Date of filing: 28.05.2025
(51) Int. Cl.: H05K 1/18, H01M 10/42, H01M 50/569

(54) **FLEXIBLE PRINTED CIRCUIT FOR A RECHARGEABLE BATTERY PACK**

(71) Applicant: Super B International Holding B.V., 7559 SC Hengelo (NL)
(72) Inventor: Zilvold, Marten Johan, 7559 SC Hengelo (NL); Van Wijk, Wouter Uco, 7559SC Hengelo (NL)
(74) Representative: Nederlandsch Octrooibureau

(57) **Abstract**

A Flexible Printed Circuit (1), FPC, for a battery pack (B) comprising a plurality of battery cells (c1, c2) connected in series, comprising a flexible substrate (2) and a main connector (3) mounted thereon, and wherein the flexible substrate (2) comprises a first cell connector (4), a second cell connector (5) and a third cell connector (6). A first switch member (7) and a first dissipative member (8) are arranged in series on the flexible substrate (2) and connected to the first cell connector (4) and the second cell connector (5). A second switch member (9) and a second dissipative member (10) are arranged in series on the flexible substrate (2) and connected to the second cell connector (5) and the third cell connector (6). The first and second switch member (7, 9) are connected to the main connector (3) for communication with a battery management system (S).

## Description

### Field of the invention

The present invention relates to a flexible printed circuit for a rechargeable battery pack, in particular for a rechargeable battery pack comprising a plurality of battery cells connected in series.

### Background

Flexible printed circuit boards, or flexible printed circuits for short, are known and used in a wide variety of applications to connect electronic components thereof. Typically, a flexible printed circuit comprises a flat flexible film or substrate provided with one or more layers of electrically conductive material, wherein the flexible printed circuit replaces traditional wires for making electrical connections.

US patent application US 2023/395878 A1 discloses an exemplary application of a flexible printed circuit in a battery. In particular, a battery is disclosed comprising multiple cell units that are connected in series in such a manner that positive and negative electrodes of adjacent ones of the cell units are electrically connected to each other via a bus bar functioning as a terminal. A battery monitoring module is attached to an upper portion of the battery and includes a flexible printed circuit and a connector connected to an edge portion of the flexible printed circuit, wherein conductive lines of the flexible printed circuit are connected to the bus bars.

### Summary

The present invention seeks to provide a Flexible Printed Circuit, FPC, for a rechargeable battery pack comprising a plurality of battery cells connected in series. The FPC of the present invention is configured to connect battery cells of a battery pack to a Battery Management System, BMS, which is responsible for maintaining all battery cells in the battery back at a similar State of Charge, SoC, when the battery pack is being charged. The FPC allows simplification of the BMS to which it is connectable, making shorter electrical connections between battery cells of the battery pack and electrical components that are responsible for balancing individual battery cells. The FPC further allows rechargeable battery packs to be scalable in that the FPC can be readily adapted to efficiently connect to any number of battery cells arranged in series for connection to a BMS for balancing purposes.

According to the present invention, a flexible printed circuit, FPC, is provided of the type mentioned above, wherein the FPC comprises a flexible substrate provided with a main connector for connection to a Battery Management System, BMS, and wherein the flexible substrate (2) comprises
a first cell connector for connection to a first terminal of a first battery cell of the plurality of battery cells;
a second cell connector for connection to a second terminal of the first battery cell, and to a first terminal of a second battery cell of the plurality of battery cells; and
a third cell connector for connection to a second terminal of the second battery cell; and further comprising. The FPC further comprises
a first switch member and a first dissipative member arranged on the flexible substrate, wherein the first switch member and the first dissipative member are connected in series to the first cell connector and the second cell connector; and
a second switch member and a second dissipative member arranged on the flexible substrate, wherein the second switch member and the second dissipative member are connected in series to the second cell connector and the third cell connector; and
wherein the first switch member and the second switch member are further connected to the main connector for communication with the BMS.

Instead of discharging energy of the plurality of battery cells through a BMS for balancing purposes of a battery pack, the FPC of the present invention allows each battery cell of the plurality battery cells to be balanced/discharged locally through a corresponding switch member and dissipative member arranged on the FPC and therefore through a discharging current loop which is close to the battery cell being discharged. As a result, cumbersome routing of long wires throughout the battery pack for discharging individual battery cells is avoided, thereby allowing for a battery pack design exhibiting reduced complexity. Furthermore, a less complex BMS is achieved as there is no need for dissipative circuitry in the BMS for balancing individual battery cells as this dissipative circuitry is now comprised by the FPC. Another advantage of the FPC is the ability to allow battery packs to scale-up easily, wherein the FPC can be readily adapted to connect to an increasing number of battery cells as dissipative circuitry of the FPC scales-up in unison with each battery cell added to the battery pack.

### Short description of drawings

The present invention will be discussed in more detail below, with reference to the attached drawings, in which
Figure 1 depicts a schematic view of a prior art electrical arrangement of a battery pack comprising a plurality of cells connected in series, and wherein the battery pack is connected to a battery management system for balancing each cell of the plurality of cells during charging;
Figure 2 shows a top view of a flexible printed circuit connected to a plurality of battery cells according to a first embodiment of the present invention;
Figure 3 shows a top view of a flexible printed circuit connected to a plurality of battery cells according to a second embodiment of the present invention;
Figure 4 shows a top view of a flexible printed circuit for connection to a plurality of battery cells according to a third embodiment of the present invention;
Figure 5 shows a three dimensional view of battery pack comprising a flexible printed circuit according to an embodiment of the present invention.

### Detailed description of embodiments

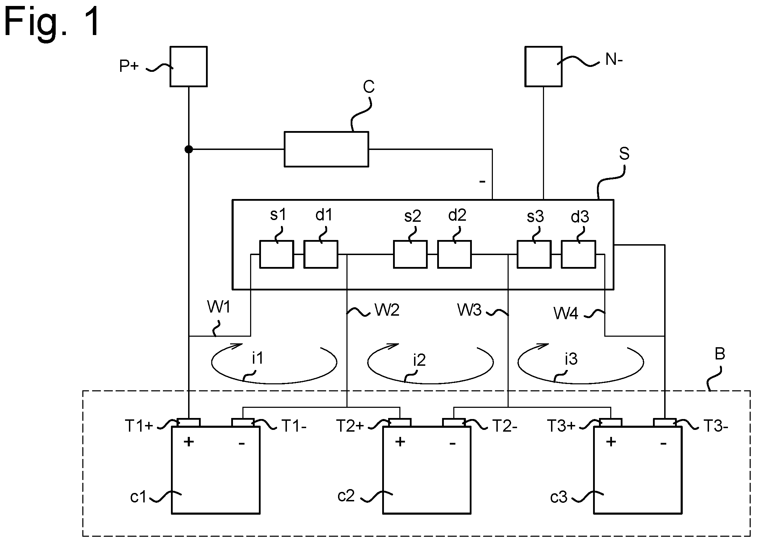

Figure 1 depicts a prior art rechargeable battery pack B comprising a plurality of battery cells c1, c2, c3 arranged in series. A positive terminal P+ of the battery pack B is connected to a positive terminal T1+ of a first battery cell c1 of the series arrangement of battery cells c1, c2, c3, and wherein the negative terminal N- of the battery pack B is connected to a negative terminal T3-of a last battery cell c3 of the series arrangement of battery cells c1, c2, c3.

To recharge the battery pack B and ensuring that each battery cell c1, c2, c3 maintains a similar State of Charge (SoC), i.e. a similar voltage across corresponding terminals T1+, T1-; T2+, T2-; and T3+, T3-, a Battery Management System S, BMS S, is utilized connected to a charger C and connected to the battery pack B. The BMS S is connected to the battery pack B by a plurality of discharging wires w1, w2, w3, w4 that allow for balancing/discharging each battery cell c1, c2, c3 through corresponding discharge loops i1, i2, i3 as depicted. For example, the first battery cell c1 is dischargeable through a first discharge loop i1, and wherein the last battery cell c3 is dischargeable through a last discharge loop i3.

As depicted in Figure 1, a BMS S may comprise a plurality of dissipative members d1, d2, d3 each which is configured for arrangement in a corresponding discharge loop i1, i2, i3 for discharging the corresponding battery cell c1, c2, c3. Each of the dissipative members d1, d2, d3 may be individually activated or controlled, for example, by means of a corresponding switch member s1, s2, s3 in series with the dissipative member d1, d2, d3.

It is important to note that the term "cell balancing" or "cell discharging" often used in the field of rechargeable batteries typically refers to the process of discharging one or more battery cells such that their SoC becomes the same. Therefore, the terminology "cell balancing" or "cell discharging" may be considered equivalent for the purpose of the present invention.

Even though the depicted prior art arrangement of the battery pack B and the BMS S has works effectively, the routing of the plurality discharging wires w1, w2, w3, w4 through the battery pack B adds complexity and increases cost of the battery pack B. Also, the BMS S used for the battery pack B must allow for each discharging wire w1, w2, w3, w4, to be connected to the BMS S for discharging battery cells therethrough and as such the design of the BMS S and complexity thereof is at least in part determined by the number of cells of the battery pack B.

In view of these aforementioned complexities, there is a need for a simpler and cost effective design of a battery pack B which can be interfaced with a BMS more efficiently.

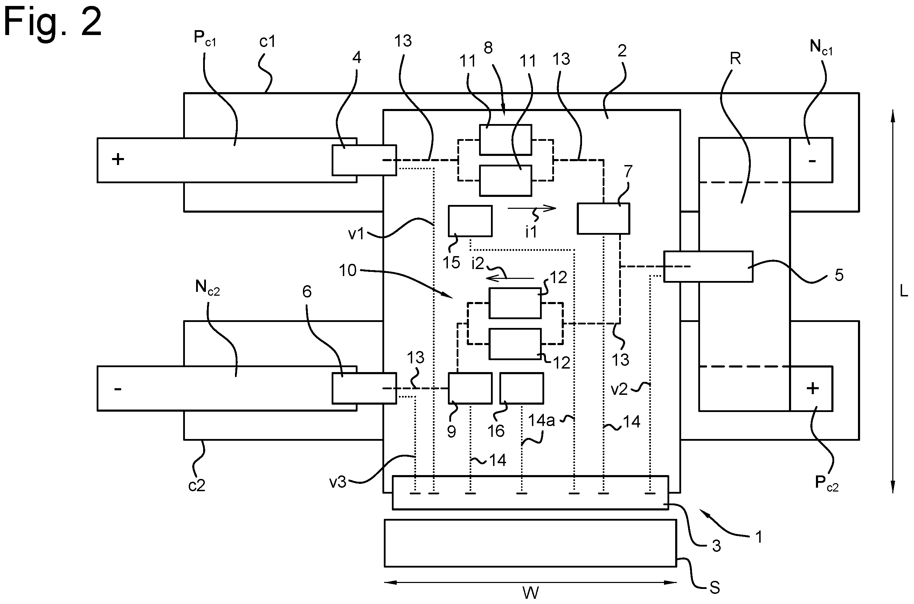

To allow for such a simpler and cost effective battery pack B, Figure 2 shows a top view of a Flexible Printed Circuit 1, FPC, connected to a plurality of cells c1, c2 arranged in series according to an embodiment of the present invention. The FPC 1 comprises a flexible substrate 2 having mounted thereon a main connector 3 for connection to a Battery Management System S, BMS S. The flexible substrate 2 further comprises
a first cell connector 4 configured for connection to a first terminal Pc1 of a first battery cell c1 of the plurality of battery cells c1, c2;
a second cell connector 5 configured for connection to a second terminal Nc1 of the first battery cell c1, and to a first terminal Pc2 of a second battery cell c2 of the plurality of battery cells c1, c2; and
a third cell connector 6 configured for connection to a second terminal Nc2 of the second battery cell c2.

As shown, the FPC 1 further comprises:
a first switch member 7 and a first dissipative member 8 arranged on the flexible substrate 2, and wherein the first switch member 7 and the first dissipative member 8 are connected, i.e. electrically connected, in series to the first cell connector 4 and the second cell connector 5;
a second switch member 9 and a second dissipative member 10 arranged on the flexible substrate 2, and wherein the second switch member 9 and the second dissipative member 10 are connected, i.e. electrically connected, in series to the second cell connector 5 and the third cell connector 6. The first switch member 7 and the second switch member 9 are further connected to the main connector 3 for communication with the BMS S.

The FPC 1 as described above allows the first battery cell c1 and the second battery cell c2 of the plurality of battery cells c1, c2 to be discharged through the first dissipative member 8 and the second dissipative member 10, respectively, as indicated by a corresponding first discharging current i1 and a second discharging current i2. The first dissipative member 8 and the second dissipative member 10 are each configured to dissipate discharged energy from the corresponding first battery cell c1 and second battery cell c2, thereby lowering the SoC of the first battery cell c1 and second battery cell c2 accordingly.

The first switch member 7 is switchable to establish the first discharging current i1 through the first dissipative member 8 when required, and the second switch member 9 is switchable to establish the second discharging current i2 through the second dissipative member 10. External control of the first switch member 7 and/or the second switch member 9 to a conductive or nonconductive state is achieved by virtue of the main connecter 3. Advantageously, a BMS S for controlling the discharging of the plurality of battery cells c1, c2 merely needs to implement logical functions for controlling the first switch member 7 and the second switch member 9. Furthermore, discharging current loops for the first discharging current i1 and the second discharging current i2 are much shorter by being locally provided at the FPC 1.

In an exemplary embodiment, the first switch member 7 and the second switch member 9 each comprise a semiconductor switch, which can be readily controlled by a BMS S via the main connector 3.

Instead of discharging the plurality of battery cells c1, c2 via a BMS S, the FPC 1 of the present invention allows each battery cell of the plurality battery cells c1, c2 to be locally discharged through the corresponding first and second dissipative members 8, 10 arranged on the flexible substrate 2. As a result, complex and cumbersome routing of long discharging wires through a battery pack B to a BMS S is avoided, which in turn allows for a simpler design of the battery pack B. Furthermore, a less complex design of a BMS S is required as there is no need for dissipative circuitry in the BMS S, i.e. the dissipative circuitry is comprised by the FPC 1 and local to each battery cell connected to the FPC 1. Another advantage of the FPC 1 of the present invention is the ability to readily adapt to a larger battery pack B having more battery cells. That is, the FPC 1 is easily adapted to a larger number of battery cells as dissipative circuitry of the FPC 1, i.e. dissipative members, scales-up with each battery cell added to the battery pack B.

As further depicted in Figure 1, in many applications a conductive connecting bar or strip R will be utilized to obtain the series connection of the first and second battery cells c1, c2. For example, in the depicted embodiment the connecting bar R connects the second terminal Nc1 of the first battery cell c1 and the first terminal Pc2 of the second battery cell c2. The second cell connector 5 may then be connected to the connecting bar R instead of directly connecting to the second terminal Nc1 of the first battery cell c1 and the first terminal Pc2 of the second battery cell c2.

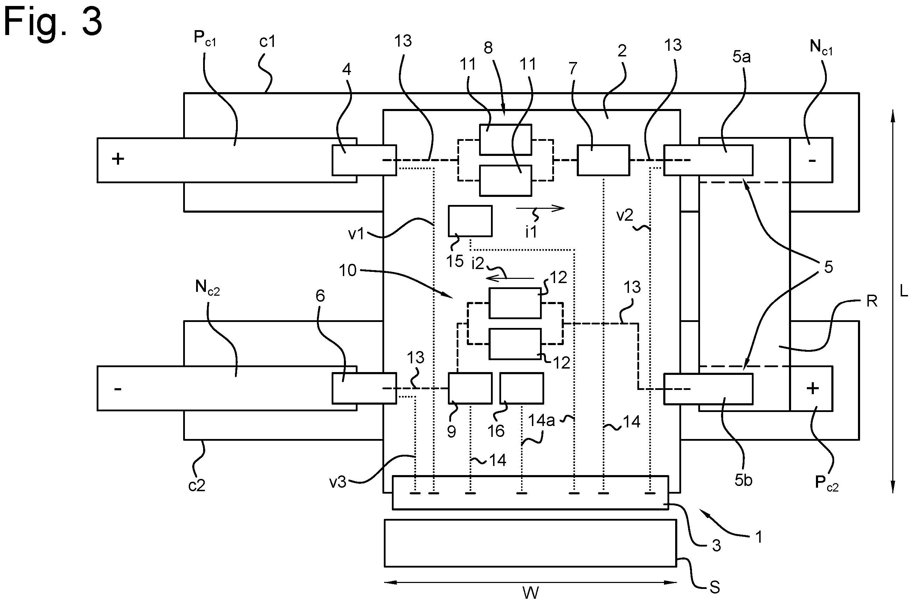

Figure 3 shows an another embodiment wherein the second cell connector 5, comprises a first connector part 5a spaced apart from a second connector part 5b in a length direction L of he flexible substrate 2. This embodiment may be utilised to achieve shorter discharging current loops for each of the battery cells c1, c2, noting that the first connector part 5a can be connected closer to the second terminal Nc1 of the first battery cell c1, and wherein the second connector part 5b can be connected closer the first terminal Pc2 of the second battery cell c2. Furthermore, the first connector part 5a and second connector part 5b may be connected directly to the second terminal Nc1 of the first battery cell c1 and first terminal Pc2 of the second battery cell c2, respectively.

Further, in the embodiment shown, the first connector part 5a may be arranged opposite the first cell connector 4 and aligned therewith in the length direction L, and wherein the second connector part 5b may be arranged opposite the third cell connector 6 and aligned therewith in the length direction L. This embodiment may be advantageous for aligning the first cell connector 4 and the first connector part 5a with the first and second terminal Pc1, Nc1 of the first battery cell c1, and for aligning the third cell connector 6 and the second connector part 5b with the first and second terminal Pc2, Nc2 of the second battery cell c2. This allows for a shortest discharging current loop for balancing each of the first and second battery cell c1, c2.

Note that the flexible substrate 2 as depicted in Figure 2 and 3 is considered to be rectangular, so wherein the flexible substrate 2 is longer in the length direction L than it is wide in the width direction W.

In an embodiment, the first dissipative member 8 is a first resistive member and the second dissipative member 10 is a second resistive member. Here, the first and second battery cells c1, c2 can be individually balanced/discharged through the first and second resistive member, respectively, wherein discharged energy is dissipated as heat.

In a further embodiment, the first resistive member comprises a parallel arrangement of two or more first resistors 11, and wherein the second resistive member comprises a parallel arrangement of two or more second resistors 12. This embodiment allows the first discharging current i1 and the second discharging current i2 to flow through a parallel arrangement of resistors, so that smaller resistors can be utilized for dissipating energy.

As further depicted in Figure 2 and 3, in an embodiment the flexible substrate 2 comprises a plurality of first conductive lines 13 for connecting the first switch member 7 and the first dissipative member 8 in series to the first cell connector 4 and the second cell connector 5, and for connecting the second switch member 9 and the second dissipative member 10 in series to the second cell connector 5 and the third cell connector 6. Furthermore, the flexible substrate 2 comprises a plurality of second conductive lines 14 for connecting the first switch member 7 and the second switch member 9 to the main connector 3. The plurality of first conductive lines 13 are configured to carry the first and second discharging currents i1, i2 when the plurality of battery cells c1, c2 are being balanced/discharged. The plurality of second conductive lines 14 are configured for communication with a BMS S via the main connector 3, so that the BMS S can send a signal for opening the first switch member 7 and/or the second switch member 9, thereby balancing/discharging the first battery cell c1 and/or the second battery cell c2 through the first dissipative member 8 and/or second dissipative member 10 respectively.

Note that in an advantageous embodiment the flexible substrate 2 may further comprise a first voltage line v1, a second voltage line v2, and a third voltage line v3 connecting the first cell connector 4, the second cell connector 5, and the third cell connector 6, respectively, to the main connector 3. This allows the BMS S to measure corresponding voltages at each of the first, second and third cell connector 4, 5, 6.

In an advantageous embodiment, the plurality of first conductive lines 13 comprise larger conductive cross sections than conductive cross sections of the plurality of second conductive lines 14. As balancing the plurality of battery cells c1, c2 may cause relatively high discharging currents to develop, the larger conductive cross sections of the plurality of first conductive lines 13 reduce resistance and as such heat development in the flexible substrate 2 is minimized. On the other hand, the conductive cross sections of the plurality of second conductive lines 14 can be smaller than those of the plurality of first conductive lines 13 as the plurality of second conductive lines 14 only need to carry low power control signals, e.g. logical signals for switching the first switch member 7 and the second switch member 9.

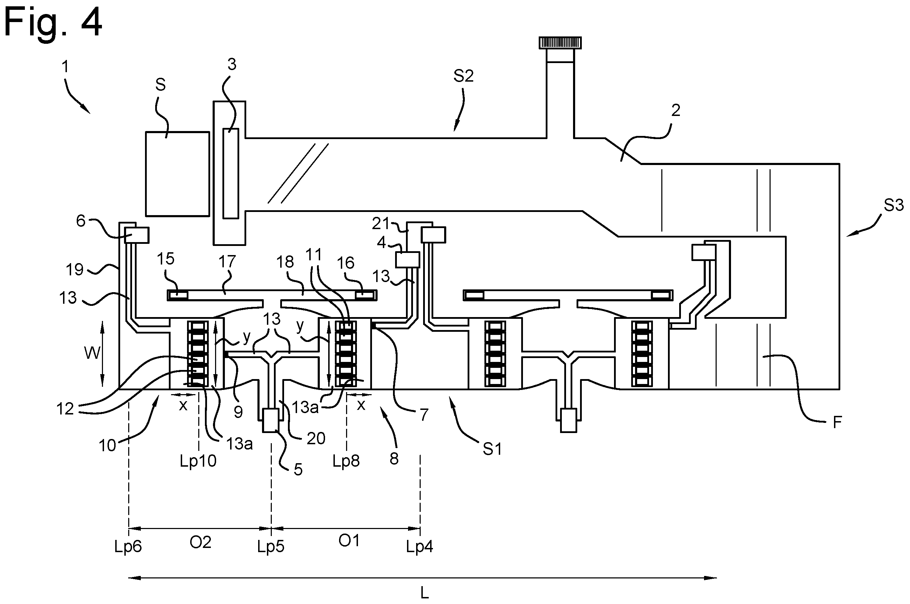

In Figure 4 there is shown another exemplary embodiment of the FPC 1, wherein the first cell connector 4 and the second cell connector 5 are spaced apart at a first offset distance O1 in the length direction L of the flexible substrate 2, and wherein the first dissipative member 8 is arranged at a length position Lp8 along the flexible substrate 2 between a length position Lp4 of the first cell connector 4 and a length position Lp5 of the second cell connector 5. This ensures that improved routing of the plurality of first conductive lines 13 on both sides of the first dissipative member 8 in the length direction L is achieved, and that there is sufficient space for the first dissipative member 8 to be arranged on the flexible substrate 2. Furthermore, the discharging current loop for the first discharging current i1 between the first and second cell connector 4, 5 is as short as possible and locally arranged at the first battery cell c1.

In a similar embodiment, the second cell connector 5 and the third cell connector 6 are spaced apart at a second offset distance O2 in the length direction L of the flexible substrate 2, and wherein the second dissipative member 10 is arranged at a length position Lp10 along the flexible substrate 2 between a length position Lp5 of the second cell connector 5 and a length position Lp6 of the third cell connector 6. Likewise, this embodiment ensures that improved routing of the plurality of first conductive lines 13 on both sides of the second dissipative member 10 in the length direction L is achieved, and that sufficient space is available for the second dissipative member 10 to be arranged on the flexible substrate 2. The discharging current loop for the second discharging current i2 between the second and third cell connector 5, 6 is as short as possible and locally arranged at the second battery cell c2.

Like the embodiments of Figure 2 and 3, the flexible substrate 2 of Figure 4 is considered to be longer in the length direction L than it is wide in the width direction W.

It was mentioned earlier that the first dissipative member 8 may comprise a parallel arrangement of two or more first resistors 11, and that the second dissipative member 10 may comprise a parallel arrangement of two or more second resistors 12.

Figure 4 shows an embodiment wherein the parallel arrangement of the two or more first resistors 11 extends in a width direction W of the flexible substrate 2, and wherein the parallel arrangement of two or more second resistors 12 extends in the width direction W of the flexible substrate 2. The parallel arrangement of two or more second and first resistors 11, 12 extending in the width direction W takes op less space in the length direction L of the flexible substrate 2, so that the parallel arrangement of two or more first resistors 11 can be efficiently placed at the length position Lp8 between the length position Lp4 of the first cell connector 4 and the length position Lp5 of the second cell connector 5. Likewise, the parallel arrangement of two or more second resistors 12 can be efficiently placed at the length position Lp10 between the length position Lp5 of the second cell connector 5 and the length position Lp6 of the third cell connector 6. Therefore, this embodiment is advantageous when space for the first and second dissipative members 8, 10 is limited in the length direction L of the flexible substrate 2.

As further shown in Figure 4, an embodiment is depicted wherein the plurality of conductive lines 13 for connection to both sides of the two or more first resistors 11 and the two or more second resistors 12 may provide enlarged connecting ends 13a for connecting to the parallel arrangement of two or more first and second resistors 11, 12. In particular, each of the enlarged connecting ends 13a provides an enlarged conductive area having a length x (in length direction L) and width y (in width direction W) for efficient connection to the parallel arrangement of the two or more first and second resistors 11, 12.

Another embodiment is depicted in Figure 2, wherein the parallel arrangement of the two or more first resistors 11 extends in a length direction L of the flexible substrate 2, and wherein the parallel arrangement of two or more second resistors 12 extends in the length direction L of the flexible substrate 2. This embodiment is advantageous when space in the width direction W of the flexible substrate 2 is limited for accommodating the parallel arrangement of the two or more first resistors 11 and the two or more second resistors 12.

In an embodiment as shown in Figure 4, the flexible substrate 2 comprises a first flexible end section S1, a second flexible end section S2, and a flexible mid section S3 between the first flexible end section S1 and the second flexible end section S2. The first flexible end section S1 comprises the first cell connector 4, the second cell connector 5, and the third cell connector 6. The second flexible end section S2 comprises the main connector 3 for connection to a BMS S. The flexible substrate 2 further comprises a bend zone F between the first flexible end section S1 and the flexible mid section S3 for arranging the flexible midsection S3 at an angle with respect to the first flexible end section S1. The flexible mid section S3, and in particular the bend zone F of the flexible substrate 2, allows the FPC 1 to snugly fit inside a battery pack B , wherein the second flexible end zone S2 with the main connector 3 can be given a different orientation inside the battery pack B. In an embodiment, the bend zone F extends in the width direction W of the flexible substrate 2.

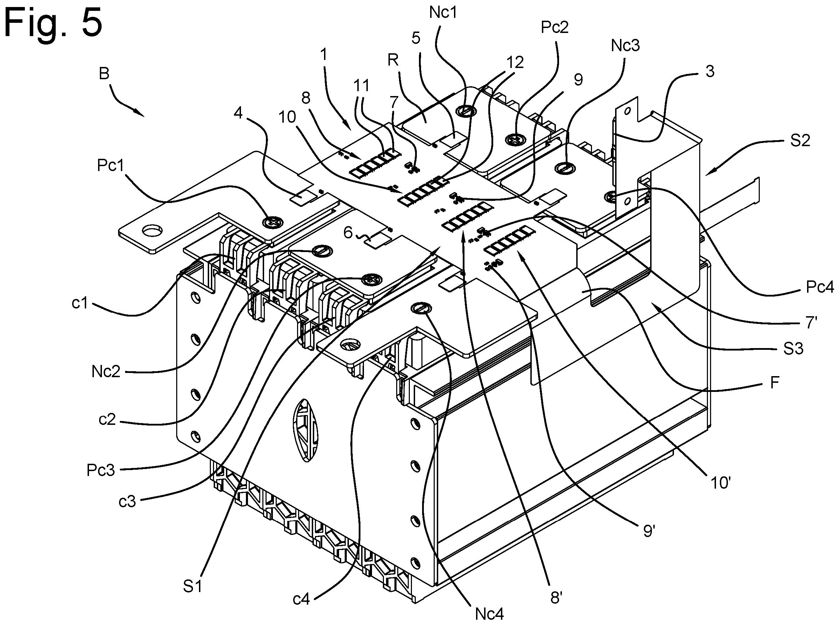

An example of how the FPC 1 can be arranged in a battery pack B is shown in Figure 5. The aforementioned first flexible end section S1 spans transversely over the plurality of cells c1, c2, wherein the first cell connector 4 is connected to the first terminal Pc1 of the first battery cell c1. A conductive connecting bar or strip R is connected to the second terminal Nc1 of the first battery cell c1, and to the first terminal Pc2 of a second battery cell c2. The second cell connector 5 is then connected to the connecting bar R, hence connecting the second cell connector 5 to the second terminal Nc1 of the first battery cell c1 and to the first terminal Pc2 of the second battery cell c2. The third cell connector 6 is connected to the second terminal Nc2 of the second battery cell c2.

As depicted, the flexible mid section S3 is bend at the bend zone F substantially perpendicular to the first flexible end section S1 so that the second flexible end section S2 is arranged in a different orientation in the battery pack B, thereby allowing the main connector 3 to attain a required orientation with respect to the battery pack B. Furthermore, the bend zone F allows the flexible mid section S3 to bend away and extend along a side wall of the battery back B to snugly fit therein.

Referring to Figure 2, the FPC 1 may further comprise a plurality of temperature sensors 15, 16 arranged on the flexible substrate 2 in correspondence with (i.e. in equal number) the plurality of battery cells c1, c2. Each temperature sensor 15, 16 is connected to the main connector 3, see e.g. the plurality of auxiliary conductive lines 14a, and configured for measuring a temperature of a corresponding battery cell of the plurality of battery cells c1, c2.

In this embodiment, the FPC 1 provides an efficient and convenient way to measure the temperature of each of the battery cells c1, c2 by providing the FPC1 with the plurality of temperature sensors 15, 16, which readily interface with the BMS S via the main connector 3. Consequently, separate temperature sensors and corresponding wiring routed through the battery pack B is avoided, thereby reducing the complexity and cost of the battery pack B.

In an advantageous embodiment as depicted in Figure 4, the flexible substrate 2 comprises a plurality of protruding substrate portions 17, 18 in correspondence (i.e. in equal number) with the plurality of temperature sensors 15, 16, and wherein each protruding substrate portion 17, 18 comprises a corresponding temperature sensor of the plurality of temperature sensors 15, 16. The protruding substrate portions 17, 18 can bend to allow each temperature sensor 15, 16 arranged on the flexible substrate 2 to be brought into close proximity or in contact with a corresponding battery cell c1, c2 for measuring the temperature of the corresponding battery cell c1, c2 with improved accuracy.

In a similar embodiment, the first cell connector 4, the second cell connector 5 and/or the third cell connector 6 may each be arranged on a corresponding protruding tab portion 19, 20, 21 of the flexible substrate 2. The protruding tab portions 19, 20, 21 allow:
the first cell connector 4 to be brought into contact with the first terminal Pc1 of the first battery cell c1;
the second cell connector 5 to be brought into contact with the first terminal Pc2 of the second battery cell c2 and the second terminal Nc1 of the first battery cell c1, i.e. via a connecting bar R or directly to the corresponding first and second terminals Pc2, Nc1; and
the third cell connector 6 to be brought into contact with second terminal Nc2 of the second battery cell c2.

Both the protruding substrate portions 17, 18 and the protruding tab portions 19, 20, 21 of the flexible substrate 2 allow the FPC 1 to span across and above the plurality of battery cells c1, c2, and wherein both the protruding substrate portions 17, 18 and the protruding tab portions 19, 20, 21 can bend to allow the temperature sensors 15, 16 and the first, second and third cell connectors 4, 5, 6 to make contact with the battery cells c1, c2 and terminals Pc1, Nc1, Pc2, Nc1 thereof, respectively.

According to the present invention, the FPC 1 is readily scalable for connection to any number of battery cells that are connected in series. That is, the FPC 1 of the present invention is adaptable for connection to any plurality of battery cells connected in series, with a minimum of two battery cells connected in series, i.e. the first and second battery cells c1, c2 as mentioned in detail above. However, as shown in Figure 5, a series connection of four battery cells c1, c2, c3, c4 is readily achievable. The main principle of the FPC 1 is that for each battery cell of a plurality of battery cells c1, c2, c3, c4 a corresponding dissipative member 8, 10, 8', 10' and corresponding switch member 7, 9, 7, '9' is provided on the flexible substrate 2 for allowing each battery cell c1, c2, c3, c4 to be individually balanced/discharged to attain a similar SoC with respect to other battery cells. The series connection of each corresponding dissipative member 8, 10, 8', 10' and switch member 7, 9, 7', '9' allows for discharging current loops (not shown) between corresponding terminals Pc1, Nc1; Pc2, Nc1; Pc3, Nc3; and Pc4, Nc4 that are very short in length and in close proximity to the corresponding battery cell c1, c2, c3, c4. Each switch member 7,9,7',9' is connected to the main connector 3 for being controlled by a BMS. In this way the FPC 1 eliminates the use of separate discharge wiring throughout the battery pack B, thus simplifying the design thereof. Furthermore, this also leads to a less complex BMS for connection to the main connector 3 as dissipative components for battery balancing are now provided on the flexible substrate 2 instead of being part of the BMS. Subsequently, The BMS need only provide logic functions for switching the plurality switch members 7, 9, 7',9'.

In view of the above, present invention can now be summarised by the following embodiments:
Embodiment 1. A Flexible Printed Circuit (1), FPC, for a battery pack (B) comprising a plurality of battery cells (c1, c2) connected in series, comprising
   a flexible substrate (2) having mounted thereon a main connector (3) for connection to a battery management system (S), and wherein the flexible substrate (2) comprises:
      a first cell connector (4) configured for connection to a first terminal (P_{c1}) of a first battery cell (c1) of the plurality of battery cells (c1, c2);
      a second cell connector (5) configured for connection to a second terminal (N_{c1}) of the first battery cell (c1), and to a first terminal (P_{c2}) of a second battery cell (c2) of the plurality of battery cells (c1, c2); and
      a third cell connector (6) configured for connection to a second terminal (N_{c2}) of the second battery cell (c2); and wherein the FPC (1) further comprises,
   a first switch member (7) and a first dissipative member (8) arranged on the flexible substrate (2), wherein the first switch member (7) and the first dissipative member (8) are connected in series to the first cell connector (4) and the second cell connector (5); and
   a second switch member (9) and a second dissipative member (10) arranged on the flexible substrate (2), wherein the second switch member (9) and the second dissipative member (10) are connected in series to the second cell connector (5) and the third cell connector (6); and
   wherein the first switch member (7) and the second switch member (9) are further connected to the main connector (3) for communication with the battery management system (S).
Embodiment 2. The FPC (1) according to embodiment 1, wherein the first dissipative member (8) is a first resistive member and the second dissipative member (10) is a second resistive member.
Embodiment 3. The FPC (1) according to embodiment 2, wherein the first resistive member comprises a parallel arrangement of two or more first resistors (11), and wherein the second resistive member comprises a parallel arrangement of two or more second resistors (12).
Embodiment 4. The FPC (1) according to any of embodiments 1-3, wherein the first switch member (7) and the second switch member (9) each comprise a semiconductor switch.
Embodiment 5. The FPC (1) according to any of embodiments 1-4, wherein the flexible substrate (2) comprises
   a plurality of first conductive lines (13) for connecting the first switch member (7) and the first dissipative member (8) in series to the first cell connector (4) and the second cell connector (5), and for connecting the second switch member (9) and the second dissipative member (10) in series to the second cell connector (5) and the third cell connector (6); and
   a plurality of second conductive lines (14) for connecting the first switch member (7) and the second switch member (9) to the main connector (3), and wherein the plurality of first conductive lines (13) comprise larger conductive cross sections than conductive cross sections of the plurality of second conductive lines (14).
Embodiment 6. The FPC (1) according to any of embodiments 1-5, wherein the first cell connector (4) and the second cell connector (5) are spaced apart at a first offset distance (O1) in a length direction (L) of the flexible substrate (2), and wherein the first dissipative member (8) is arranged at a length position (Lp8) along the flexible substrate (2) between a length position (Lp4) of the first cell connector (4) and a length position (Lp5) of the second cell connector (5).
Embodiment 7. The FPC (1) according to any of embodiments 1-6, wherein the second cell connector (5) and the third cell connector (6) are spaced apart at a second offset distance (O2) in a length direction (L) of the flexible substrate (2), and wherein the second dissipative member (10) is arranged at a length position (Lp10) along the flexible substrate (2) between a length position (Lp5) of the second cell connector (5) and a length position (Lp6) of the third cell connector (6).
Embodiment 8. The FPC (1) according to any of embodiments 1-7, when depending from embodiment 3, wherein the parallel arrangement of the two or more first resistors (11) extends in a width direction (W) of the flexible substrate (2), and wherein the parallel arrangement of two or more second resistors (12) extends in the width direction (W) of the flexible substrate (2).
Embodiment 9. The FPC (1) according to any of embodiments 1-7, when depending from embodiment 3, wherein the parallel arrangement of the two or more first resistors (11) extends in a length direction (L) of the flexible substrate (2) and wherein the parallel arrangement of two or more second resistors (12) extends in the length direction (L) of the flexible substrate (2).
Embodiment 10. The FPC (1) according to any of embodiments 1-9, wherein the flexible substrate (2) comprises a first flexible end section (S1), a second flexible end section (S2), and a flexible mid section (S3) between the first flexible end section (S1) and the second flexible end section (S2), and
   wherein the first flexible end section (S1) comprises the first cell connector (4), the second cell connector (5), and the third cell connector (6); and
   wherein the second flexible end section (S2) comprises the main connector (3), and
   wherein the flexible substrate (2) further comprises a bend zone (F) between the first flexible end section (S1) and the flexible mid section (S3) for arranging the flexible midsection (S3) at an angle with respect to the first flexible end section (S1).
Embodiment 11. The FPC (1) according to any of embodiments 1-10, further comprising a plurality of temperature sensors (15, 16) arranged on the flexible substrate (2) in correspondence with the plurality of battery cells (c1, c2), wherein each temperature sensor (15, 16) is connected to the main connector (3), and wherein each temperature sensor is (15, 16) is configured for measuring a temperature of a corresponding battery cell of the plurality of battery cells (c1, c2). Embodiment 12. The FPC (1) according to embodiment 11, wherein the flexible substrate (2) comprises a plurality of protruding substrate portions (17, 18) in correspondence with the plurality of temperature sensors (15, 16), and wherein each protruding substrate portion (17, 18) comprises a corresponding temperature sensor of the plurality of temperature sensors (15, 16).
Embodiment 13. The FPC (1) according to any of embodiments 1-12, wherein the first cell connector (4), the second cell connector (5) and/or the third cell connector (6) are arranged on a corresponding protruding tab portion (19, 20, 21) of the flexible substrate (2).

The present invention has been described above with reference to a number of exemplary embodiments discussed above and as shown in the drawings. Modifications and alternative implementations of some parts or elements are possible, and are included in the scope of protection as defined in the appended claims.

## Claims

1. A Flexible Printed Circuit (1), FPC, for a battery pack (B) comprising a plurality of battery cells (c1, c2) connected in series, comprising
a flexible substrate (2) having mounted thereon a main connector (3) for connection to a battery management system (S), and wherein the flexible substrate (2) comprises:
a first cell connector (4) configured for connection to a first terminal (P_{c1}) of a first battery cell (c1) of the plurality of battery cells (c1, c2);
a second cell connector (5) configured for connection to a second terminal (N_{c1}) of the first battery cell (c1), and to a first terminal (P_{c2}) of a second battery cell (c2) of the plurality of battery cells (c1, c2); and
a third cell connector (6) configured for connection to a second terminal (N_{c2}) of the second battery cell (c2); and wherein the FPC (1) further comprises,
a first switch member (7) and a first dissipative member (8) arranged on the flexible substrate (2), wherein the first switch member (7) and the first dissipative member (8) are connected in series to the first cell connector (4) and the second cell connector (5); and
a second switch member (9) and a second dissipative member (10) arranged on the flexible substrate (2), wherein the second switch member (9) and the second dissipative member (10) are connected in series to the second cell connector (5) and the third cell connector (6); and
wherein the first switch member (7) and the second switch member (9) are further connected to the main connector (3) for communication with the battery management system (S).

2. The FPC (1) according to claim 1, wherein the first dissipative member (8) is a first resistive member and the second dissipative member (10) is a second resistive member.

3. The FPC (1) according to claim 2, wherein the first resistive member comprises a parallel arrangement of two or more first resistors (11), and wherein the second resistive member comprises a parallel arrangement of two or more second resistors (12).

4. The FPC (1) according to any of claims 1-3, wherein the first switch member (7) and the second switch member (9) each comprise a semiconductor switch.

5. The FPC (1) according to any of claims 1-4, wherein the flexible substrate (2) comprises
a plurality of first conductive lines (13) for connecting the first switch member (7) and the first dissipative member (8) in series to the first cell connector (4) and the second cell connector (5), and for connecting the second switch member (9) and the second dissipative member (10) in series to the second cell connector (5) and the third cell connector (6); and
a plurality of second conductive lines (14) for connecting the first switch member (7) and the second switch member (9) to the main connector (3), and wherein the plurality of first conductive lines (13) comprise larger conductive cross sections than conductive cross sections of the plurality of second conductive lines (14).

6. The FPC (1) according to any of claims 1-5, wherein the first cell connector (4) and the second cell connector (5) are spaced apart at a first offset distance (O1) in a length direction (L) of the flexible substrate (2), and wherein the first dissipative member (8) is arranged at a length position (Lp8) along the flexible substrate (2) between a length position (Lp4) of the first cell connector (4) and a length position (Lp5) of the second cell connector (5).

7. The FPC (1) according to any of claims 1-6, wherein the second cell connector (5) and the third cell connector (6) are spaced apart at a second offset distance (O2) in a length direction (L) of the flexible substrate (2), and wherein the second dissipative member (10) is arranged at a length position (Lp10) along the flexible substrate (2) between a length position (Lp5) of the second cell connector (5) and a length position (Lp6) of the third cell connector (6).

8. The FPC (1) according to any of claims 1-7, when depending from claim 3, wherein the parallel arrangement of the two or more first resistors (11) extends in a width direction (W) of the flexible substrate (2), and wherein the parallel arrangement of two or more second resistors (12) extends in the width direction (W) of the flexible substrate (2).

9. The FPC (1) according to any of claims 1-7, when depending from claim 3, wherein the parallel arrangement of the two or more first resistors (11) extends in a length direction (L) of the flexible substrate (2) and wherein the parallel arrangement of two or more second resistors (12) extends in the length direction (L) of the flexible substrate (2).

10. The FPC (1) according to any of claims 1-9, wherein the flexible substrate (2) comprises a first flexible end section (S1), a second flexible end section (S2), and a flexible mid section (S3) between the first flexible end section (S1) and the second flexible end section (S2), and
wherein the first flexible end section (S1) comprises the first cell connector (4), the second cell connector (5), and the third cell connector (6); and
wherein the second flexible end section (S2) comprises the main connector (3), and
wherein the flexible substrate (2) further comprises a bend zone (F) between the first flexible end section (S1) and the flexible mid section (S3) for arranging the flexible midsection (S3) at an angle with respect to the first flexible end section (S1).

11. The FPC (1) according to any of claims 1-10, further comprising a plurality of temperature sensors (15, 16) arranged on the flexible substrate (2) in correspondence with the plurality of battery cells (c1, c2), wherein each temperature sensor (15, 16) is connected to the main connector (3), and wherein each temperature sensor is (15, 16) is configured for measuring a temperature of a corresponding battery cell of the plurality of battery cells (c1, c2).

12. The FPC (1) according to claim 11, wherein the flexible substrate (2) comprises a plurality of protruding substrate portions (17, 18) in correspondence with the plurality of temperature sensors (15, 16), and wherein each protruding substrate portion (17, 18) comprises a corresponding temperature sensor of the plurality of temperature sensors (15, 16).

13. The FPC (1) according to any of claims 1-12, wherein the first cell connector (4), the second cell connector (5) and/or the third cell connector (6) are arranged on a corresponding protruding tab portion (19, 20, 21) of the flexible substrate (2).
